Europäisches Patentamt

European Patent Office

Office européen des brevets

(11) Publication number: **0 147 697 B1**

## EUROPEAN PATENT SPECIFICATION

(45) Date of publication of patent specification: **27.02.91** (51) Int. Cl.⁵: **H01L 29/796**, H01L 27/10,
//G11C19/28

(21) Application number: **84114928.9**

(22) Date of filing: **07.12.84**

(54) Charge coupled device with controllable input bias.

(30) Priority: **09.12.83 JP 232586/83**

(43) Date of publication of application:
**10.07.85 Bulletin 85/28**

(45) Publication of the grant of the patent:
**27.02.91 Bulletin 91/09**

(84) Designated Contracting States:
**DE FR GB NL**

(56) References cited:
**US-A- 4 139 784**

(73) Proprietor: **SONY CORPORATION**
**7-35 Kitashinagawa 6-Chome Shinagawa-ku**
**Tokyo 141(JP)**

(72) Inventor: **Sato, Maki**
**c/o SONY CORP. 7-35 Kitashinagawa**
**6-chome**
**Shinagawa-ku Tokyo(JP)**

(74) Representative: **TER MEER - MÜLLER - STEIN-**
**MEISTER & PARTNER**
**Mauerkircherstrasse 45**
**D-8000 München 80(DE)**

## Description

The present invention relates to charge coupled devices (CCDs) with registers, such as CCD delay lines, for transferring electrical charges.

When employing CCD delay lines a DC input bias charge is commonly applied to a input section to which input signals for the CCD delay line are applied. US-A 4,139,784 discloses a CCD comprising:

- a signal register for transferring electric charges from its input section to its output section;
- a reference register having an input section of essentially the same structure as said input section of said signal register, said first reference register transferring electric charges from its input sectin to its output section;
- and a feedback circuit for supplying a constant DC bias charge to said signal register, independently from temperature dependent characteristics of the input section of said signal register.

Feedback control of the DC input bias is performed by comparing the electric charge transferred through said reference register with a constant reference signal from a reference voltage source. However, there arises the problem, that the reference voltage should be adjusted in accordance with temperature dependent properties of the input section of the signal register.

It is the object of the present invention to provide a charge coupled device capable for automatically controlling the DC input bias charge to a constant value.

The CCD according to the present invention comprises the features as listed above for the known CCD, and it is characterized in that

- a second reference register is provided, with a maximum charge rating matching said given fraction of the maximum charge rating of said first reference register, said second reference register to be supplied by a power source with electric charges of a magnitude corresponding to said maximum charge rating thereof;
- and said feedback circuit is connected to the output sections of said both reference registers for comparing output voltages corresponding to charges transferred by said reference registers, and for supplying a feedback voltage to the input section of said signal register and said first reference register, said feedback voltage corresponding to the difference between the output voltage of said second reference register and the output voltage of said first reference register.

The present invention will be understood more fully from the detailed description given herebelow and from the accompanying drawings of the preferred embodiments of the present invention, which, however should not be taken to limit the invention to the specific embodiments but are for explanation and understanding only.

In the drawings:

Fig. 1 is a diagrammatic cross section of the preferred embodiment of a CCD system according to the present invention, applied to a two-phase, buried-channel CCD delay line with two-level, n-channel gate electrodes;

Fig. 2 is a diagrammatic plan view of the CCD system of Fig. 1;

Figs. 3, 4 and 5 are graphs showing the input/output transfer characteristics of the CCD delay line;

Fig. 6 is a diagrammataic partial cross-section of another embodiment of the CCD system according to the present invention; and

Fig. 7 is a diagrammatic partial cross-section of a further embodiment of the CCD system according to the present invention.

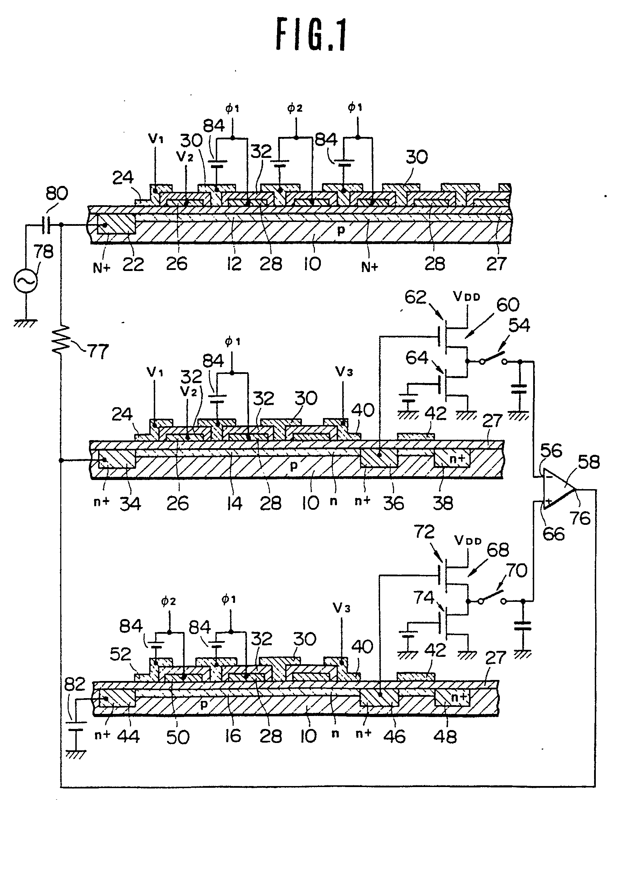

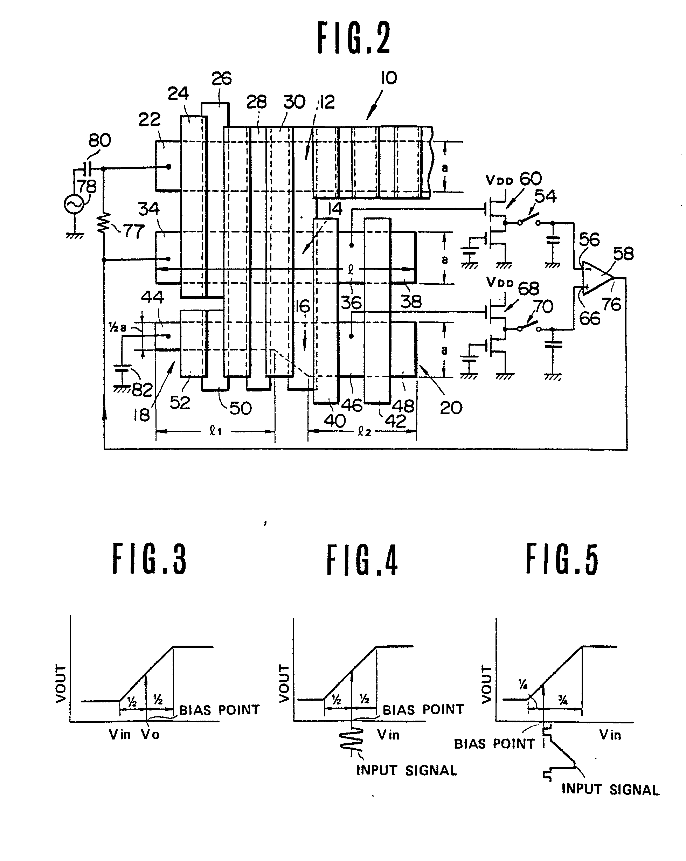

Referring now to the drawings, Figs. 1 and 2 illustrate the preferred embodiment of a charge coupled device system (CCD system) of the present invention in terms of a CCD delay line employing a two-phase, buried-channel device with two-level, n-channel gate electrodes. The CCD system has a P-type silicon substrate 10 common to a signal register (CCD delaying) 12, a first reference register 14 and a second reference register 16. The signal register 12 has a channel width $a$ and a desired number of gates. The first reference register 14 has substantially the same channel width $a$ as of the signal register 12 and a predetermined channel length $\ell$. The second reference register 16 has substantially the same channel length $\ell$ as first reference register 14. The input end section 18 of the second reference register 16 has a channel width $a/2$, i.e. only half of that of the first reference register 14 and a predetermined channel length $\ell_1$. The output end section 20 of the second reference register 16 has the same channel width as the other two registers 12, 14 and a predetermined channel length $\ell_2$. The input and output end channels of register 16 are joined by a section of tapering width. The channels of registers 12, 14 and 16 are ribbons of N-type doped silicon sandwiched between the P-type silicon substrate 10 and an insulating layer 27 of silicon dioxide.

It should be appreciated that although a specific CCD system has been illustrated to facilitate discussion of the present invention in detail, the invention can be employed in various types of CCD systems; for example, as is well-known, CCD's can be of either surface- or buried- channel type and can be driven by any of a number of control signal phasing schemes. It should also be appreciated that other electrode structures, such as single-layer or triple-layer, may be employed, and metal and polysilicon electrodes may be employed.

The signal register 12 has a source region 22 which comprises an N⁺ diffusion in the P-type silicon substrate 10. The signal register 12 also has first and second input polysilicon gate electrodes 24 and 26 deposited on the insulating layer 27 and mutually insulated by an interleaved insulating layer 32 of silicon dioxide. The signal register 12 also has a plurality of first- level electrodes 28 and a plurality of second-level electrodes 30 all of polysilicon and mutually insulated by SiO₂ layers 32.

The first and second input gate electrodes 24 and 26 extend over the channel of the first reference register 14 so that they also serve as input gate electrodes for the latter. The first- and second-level electrodes 28 and 30 extend over both the first and second reference registers 14 and 16 to serve in pairs as shift-staging electrodes for each.

The first reference register 14 has a source region 34 which is similar to that in the signal register 12 and comprises an N⁺ diffusion in P-type silicon substrate 10. The first reference register 14 also has a N⁺ floating diffusion region 36 and another N⁺ diffusion region used as a pre-charge drain region 38 following the floating diffusion region 36 but separated from the latter by a short section of a channel. The first reference register 14 also has an output gate 40 42, both of polysilicon deposited on the SiO₂ insulator 27. The output gate 40 and the pre-charge gate 42 also extend over the second reference register 16 so as to serve as output gate and the pre-charge gate for the latter.

The second reference register 16 also has a source region 44 comprising an N⁺ diffusion region in the P-type silicon substrate 10. The source region 44 is similar geometrically to the source regions of the signal register 12 and the first reference register 14. The second reference register 16 also has a N⁺ floating diffusion region 46 which is similar to that with reference number 36 in the first reference register 14. A pre-charge drain region 48 in the second reference register 16 correcponding to that with the reference number 38 in the first register 14 is similarly separated from the floating diffusion region 46 by a short section of a channel. First-level and second-level transfer electrodes 50 and 52 are also formed on the third register 16. The first- and second-level transfer electrodes 50 and 52, made of polysilicon, are located at positions corresponding to the first and second input gate electrodes 24 and 26 of the signal register 12 and the first reference register 14.

The operating states of the two switches 54 and 70 control the charge on the floating diffusion regions 36 and 46, respectively. The pre-charge drain regions 38 and 48 serve to drain the charge floating diffusion regions 36 and 46, respectively at a timing in synchronism with operation of the switches 54 and 70. For instance, an electric charge or a potential in the floating diffusion regions 36 and 46 are reset to +V_DD as constantly applied to the pre-charge drain region 38 and 48 when a resetting clock is applied to the pre-charge gate 42. The resetting clock to be applied to the pre-charge gate 42 is to be produced at a timing synchronized with the opening of the switches 54 and 70 with a given substantially short delay. By transferring the charge or potential to the pre-charge drain regions 38 and 48, the potential in the floating diffusion regions 36 and 46 is reset to +V_DD.

The floating diffusion region 36 is connected to the inverting input terminal 56 of a differential amplifier 58 via a source follower amplifier 60 and a switch 54. The source follower 60 comprises two source-drain-connected MOS FET's 62 and 64. Though the switch 54 is represented by a manual-throw switch symbol in the drawings, it may be and usually will be a MOS FET switch. Similarly, the second floating diffusion region 46 is also connected to the positive or non-inverting input terminal 66 of the differential amplifier 58 via a source follower 68 and a switch 70. As in the source follower 60, the source follower 68 comprises MOS FET 72 and 74. Again, the symbolically illustrated switch 70 will in practice be a MOS FET.

The switch ON-timing of the switches 54 and 70 are controlled by a sample/hold signal to pass the voltage corresponding to the transferred charge through the first and second registers 14 and 16. The sample/hold signal may provide a duty cycle for controlling the switch ON-timing in synchronism with the transfer of the charge through the registers 14 and 16. Therefore, the signalling timing would by synchronized with the signalling timing of the clocks φ₁ and φ₂.

The output terminal 76 of differential amplifier 58 is connected directly to the source region 34 of the first reference register 14 and to the source region 22 via a resistor 77. The source region 22 is also connected in parallel with resistor 77 to a signal source 78 via a capacitor 80. The resistor 77 is inserted to isolate the signal source 78 from the differential amplifier 58 and the first reference register 14.

It should be emphasized that the source followers 60 and 80, switches 54 and 70, the differential amplifier 58, the resistor 77 and the capacitor 80 may be formed on the same chip as the registers 10, 14 and 16,

The operation of the CCD system described above will be explained in detail. In the following description of the operation, the DC bias applied to the signal register 12 is assumed to be at the midpoint ($V_0$ in Fig. 3) of the dynamic range of the signal register.

As shown in Figs. 1 and 2, a power source 82 is connected to the source region 44 of the second reference register 16. The power source 82 is rated so as to keep the electric charge in the source region 44 saturated, in other words, to keep its potential on full carrier charged level. The first-level electrodes 28 and 50 cooperate with the adjacent second-level electrodes 30 and 52 to drive electric charges from potential well to potential well along the buried channels. In the direction of transfer each electric charge packet is determined by the potential difference between adjacent potential wells which in turn is determined by the voltage levels of the two-phase clock signals ($\phi_1$, $\phi_2$) coupled to a battery 84 as well as other operating signals described later. That is, electric charge packets migrate among the asymmetrical potential wells at the various gates and electrodes until they find the local potential minima or voltage maxima.

Each electric charge thus transferred through the second reference register 16 and output through the floating diffusion region 46 is converted into a corresponding voltage by the source follower 68. The converted voltage is sample-held by the switch 70. The switch 70 thus supplies a voltage corresponding to the maximum charge rating of the second reference register 16 to the positive input terminal 66 of the differential amplifier 58. Since the source region 44 of the second reference register 16 is always saturated, the voltage applied to the positive input terminal 66 of the differential amplifier 58 constantly corresponds to the full rating of the second reference register 16.

Upon starting the CCD system, the input voltage at the negative input terminal 56 of the differential amplifier 58 is zero, since there is no electric charge transferred to the floating diffusion region 36 of the first reference register 14. At this time, since a voltage corresponding to the maximum charge rating of the second reference register 16 is applied to the positive input terminal, the output voltage of the differential amplifier 58 corresponds to the maximum charge rating of the second reference register 16. The output voltage of the differential amplifier 58 serves as a feedback voltage for the first reference register 14. The feedback voltage from the differential amplifier 58 increases the "depth" of the potential well at the source region 34 of the first reference register 14 by an amount corresponding to the feedback voltage, which, in turn, corresponds to the full rated charge of the second reference register 16.

When predetermined sampling pulse voltages

$V_1$ and $V_2$ are applied to respective input gate electrodes 24 and 26, an electric charge corresponding to the feedback voltage is transferred to the first-level and second-level transfer electrodes 28 and 30 from the source region 34. Subsequently, repeated application of the clock pulse voltages $\phi_1$ and $\phi_2$ to the first-level and second-level transfer electrodes 28 and 30 drives the electric charge packets to the floating diffusion region 36 via the transfer electrodes. The electric charge transferred to the floating diffusion region is converted into a voltage by the source follower 60. The switch 54 then performs sample/holding of the converted voltage. The voltage obtained by sample/holding is applied to the negative input terminal 56 of the differential amplifier 58.

Since the second reference register 16 has the first-level and second-level transfer electrodes 28 and 30 and the output gate electrode 40 in common to the first reference register 14, charge transfer is performed in the second reference register 16 at substantially the same timing as in the first reference register 14. As set forth above, the charge applied to the source region 44 of the second reference register 16 corresponds to its maximum charge rating. Therefore, when a charge corresponding to the depth of the potential well in the source region 34 of the first reference register 14 is transferred to the floating diffusion region 36, the charge corresponding to the maximum charge rating of the second reference register 16 is transferred to the floating diffusion region 46 of the second reference register 16. Source followers 60 and 68 operate concurrently to convert the charge in the floating diffusion regions 36 and 46 into voltages. The switches 54 and 70 also operate concurrently. As a result, a voltage corresponding to the maximum charge rating of the second reference register 16 is applied to the positive input terminal 66 of the differential amplifier 58 simultaneously with the voltage from the switch 54.

The differential amplifier 58 outputs through its output terminal 76 a voltage corresponding to the difference between the input voltages. The output voltage of the differential amplifier 58 is fed back to the source region 34 of the first reference register 14. The feedback voltage from the differential amplifier 58 adjusts the depth of the potential well of the source region 34, specifically such that the difference between the input voltages of the differential amplifier 58 is reduced to zero. As a result, the charge transferred through the first reference register 14 is held as close as possible to the full charge transferred through the second reference register 16.

In other words, this feedback control causes the charge transferred through the first reference register 14 to match the charge output of the second reference register 16, i.e., the maximum charge rating of the second reference register 16.

As set forth above, the width of the input end section 18 of the second reference register 16 is half that of the first reference register 14, and thus the maximum charge rating of the first reference register 14 is twice that of the second reference register 16. Since the charge transferred through the first reference register 14 is feedback controlled to correspond to the maximum handling charge of the second reference register, the first reference register 14 handles half (1/2) of its maximum charge rating. In other words, the first reference register 14 operates under a bias of 1/2 of its maximum charge rating. The first reference register 14 employs the first and second input gate electrodes 24 and 26 in common with the signal register 12. Also, as set forth above, the first reference register 14 has the same channel width a as the signal register 12 and the structure of the source region 34 matches that of the source region 22 of the signal register 12. Therefore, the signal register 12 has substantially the same input structure as the first reference register. As a result, the bias condition of the signal register 12 will always be substantially equal to that of the first reference register 14. In other words, the bias on the signal register 12 substantially corresponds to 1/2 of the maximum charge rating of the first reference register 14.

This bias condition is illustrated in Fig. 3. As shown in Fig. 4, the signal register will operate at the center of its dynamic range, which is specially advantageous when the input from the signal source 78 is in the form of a sine-wave.

According to the above embodiment, due to the effect of the differential amplifier and the feedback control of the depth of the potential well of the first reference register 14, the DC bias on the signal register 12 can be automatically controlled to the center (1/2) of its dynamic range. Therefore, according to the shown embodiment, it is no longer necessary to employ a conventional amplitude control for adjustment of the DC bias on the signal register. Furthermore, it is also unnecessary to manually adjust the DC bias on the signal register, as the DC bias can be automatically controlled. In addition, since the first reference register 14 has substantially the same input structure as the signal register 12 and has substantially the same output structure as that of the second reference register 16, the input section of the first reference register 14 will be influenced by the same temperature variation as that subject to the input section of the signal register 12. On the other hand, the output section of the first register 14 will be subject to the influences of the same temperature variations as the output section of the second output register 16.

As a result, the bias on the first reference register 14 can be maintained accurately at of 1/2 its maximum charge rating. Thus, the DC input bias on the signal register 12 can be constantly maintained at 1/2 of the maximum charge rating irrespective of temperature variations.

In order to fabricate the input end section of the second reference register 16 at a channel width of precisely 1/2 the width a of the first reference register 14 and the signal register 12 in order to obtain a DC input bias corresponding to 1/2 its maximum charge rating, the photo-mask pattern used during the exposure process in semi-conductor IC fabrication process should be designed to have an input channel of the proper width. According to the present invention, the DC bias level can be set with very high accuracy simply by proper design of the photo-mask pattern. This production process also ensures good reproducability.

Furthermore, in accordance with the shown embodiment, since the channels of the signal register 12, the first reference register 14 and the second reference register 16 are aligned parallel to each other, the first-level transfer electrodes 28 and the second-level transfer electrodes 30 can conveniently be formed in common with all three registers 12, 14 and 16. Additionally, this allows the first and second input electrodes 24 and 26 of the signal register 12 and the first reference register 14 to be conveniently formed in common. Similarly, the output gate electrode 40 and the pre-charge gate 42 of the first and second reference register 14 and 16 can be formed in common.

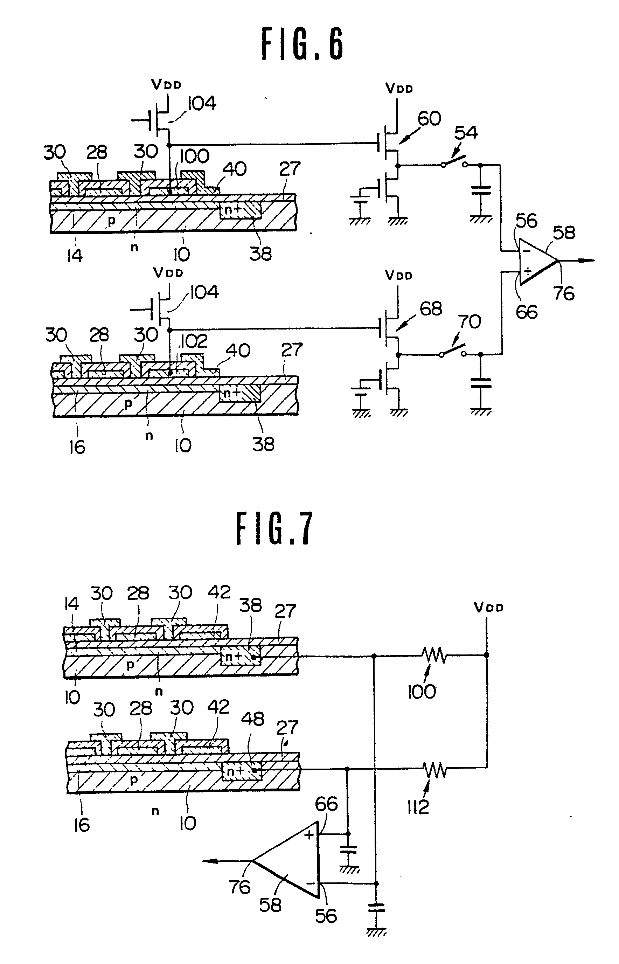

Although the aforementioned preferred embodiment has been directed to a CCD system with a signal register DC input bias set in the center of its dynamic range, the invention is not limited to this specific level, but rather can be selected to be any arbitrary value. It is only necessary to select the width of the second reference register in relation to the width of the first reference register to obtain the desired level of DC input bias. For instance, if a DC input bias lying at 3/4 of the maximum charge rating or if a dynamic range is preferred, as shown in Fig. 5, then the width of the input end section 18 of the second reference register 16 should be 3a/4, where a is the channel width of the first reference register 14 and the signal register 12. In this case, the input bias will be clamped at the voltage level of 3/4 of the dynamic range of the signal register.

In the aforementioned embodiment, the charge transferred through the first and second reference registers 14 and 16 are output to the source followers 60 and 68 through the floating diffusions regions 36 and 46 and then input to the input terminals 56 and 66 of the differential amplifier 58. However, the structure shown in Fig. 6, for example, may be used instead. In this embodiment, $N^+$

floating gates 100 and 102 made of polysilicon are formed on the P-type silicon substrate 10. The floating gates 100 and 102 are connected to the source followers 60 and 68. respectively. With this arrangement, the charge transferred through the first and second reference registers 14 and 16 can be sensed as image forces produced at the floating gates.

Reset switches 104 are connected to the floating gates 100 and 102 to control their potentials. The charges at the floating gates 100 and 102 are fed to the corresponding input terminals 56 and 66 of the differential amplifier 58 in the form of voltages corresponding to the respective charges via the source followers 60 and 68. As in the embodiment of Figs. 1 and 2, the output of the differential amplifier 58 is fed back to the first reference register 14 to control the bias thereof and accordingly the DC input bias on the signal register.

Fig. 7 shows a further embodiment of the CCD system according to the present invention. In this system, the pre-charge drain regions 38 and 48 are connected to power source $V_{DD}$ via resistors 110 and 112. The input terminals 56 and 66 of the differential amplifier 58 are connected between the pre-charge drain gates 38 and 48 and the resistors 110 and 112, respectively. As a result, voltages respectively corresponding to the voltage drops across the resistors 110 and 112 and the pre-charge drain regions 38 and 48 are applied to the input terminals 56 and 66 of the differential amplifier. Therefore, according to this embodiment, the differential amplifier compares the voltage drops respectively effected by the pre-charge drain regions 38 and 48. The output of the differential amplifier 58 is used as a feedback signal to feedback control the bias on the first reference register 14 to the desired fraction of its maximum charge rate. As a result, the DC input bias on the signal register 12 can be controlled automatically.

Although the shown embodiments employ a diode cut-off system for inputting signals to the source regions 22, 34 and 44 of the signal register 12 and the first and second reference registers 14 and 16 by exerting a voltage on the source region, other input systems, such as a potential-balance system, can be employed. When some other input system is used, the connections to the differential amplifier should be adapted accordingly so that the charge transferred through the first reference register can be constantly and automatically controlled to 1/2 of its maximum charge rate.

As will be appreciated herefrom, various modifications can be made without departing from the principle of the present invention. Therefore, the present invention should be understood as to include all of the possible embodiments and modifications providing for the same or similar effects to those illustrated hereabove. In particular, the invention should not be understood as being specifically for application to a two-phase, buried-channel CCD device with two-level, n-channel gate electrodes but should be appreciated to include various types of CCD systems including surface-channel types as well as buried-channel types, and with any practically reasonable number of clock phases.

## Claims

1. A charge coupled device comprising
   - a signal register (12) for transferring electric charges from its input section to its output section;
   - a first reference register (14) having an input section (34) of essentially the same structure as said input section (22) of said signal register, said first reference register transferring electric charges from its input section to its output section;
   - and a feedback circuit (54 - 57) for supplying a constant DC bias charge to said signal register, independently from temperature dependent characteristics of the input section of said signal register;
   **characterized in that**
   - a second reference register (16) is provided, with a maximum charge rating matching a given fraction of the maximum charge rating of said first reference register (14), said second reference register to be supplied by a power source (82) with electric charges of a magnitude corresponding to said maximum charge rating thereof;
   - and said feedback circuit (54 - 77) is connected to the output sections of said both reference registers (14, 16) for comparing output voltages corresponding to charges transferred by said reference registers, and for supplying a feedback voltage to the input section of said signal register (12) and said first reference register (14), said feedback voltage corresponding to the difference between the output voltage of said second reference register (16) and the output voltage of said first reference register (14).

2. The charge coupled device as set forth in claim 1, **characterized in that** the directions of charge transfer of said signal register (12), said first reference register (14) and said second reference register (16) are mutually parallel and said registers share a common substrate (10) and one common electrode (27).

3. The charge coupled device as set forth in claim 1 or claim 2, **characterized by** a common input gate (24) bridging the input sections of said signal register (12) and said first reference register (14).

4. The charge coupled device as set forth in one of the claims 1 - 3, **characterized in that** said second reference register (16) has an output section of essentially the same structure as the output section of said first reference register (14).

5. The charge coupled device as set forth in claim 4, **characterized in that** said first reference register (14) and said second reference register (16) have a common output gate (42).

6. The charge coupled device as set forth in one of the claims 4 or 5, **characterized in that** said first reference register (14) and said second reference register (16) have a common pre-charge gate (40).

7. The charge coupled device as set forth in one of the claims 1 - 6, **characterized in that** said second reference register (16) has an input section of substantially the same structure as that of said first reference register (14) except that said input section of said second reference register has a narrower charge transfer channel than said input section of said first reference register, whereby the ratio of the width of said both channels correponds to the ratio of said maximum charge ratings.


## Revendications

1. Dispositif à transfert de charges comprenant:
   - Un registre de signal (12) pour transférer des charges électriques de sa section d'entrée vers sa section de sortie ;
   - Un premier registre de référence (14) comportant une section d'entrée (34) présentant essentiellement la même structure que la dite section d'entrée (22) du dit registre de signal, le dit premier registre de référence transférant des charges électriques de sa section d'entrée vers sa section de sortie ;
   - et un circuit de rétroaction (54 - 57) pour alimenter le dit registre de signal sous une charge de polarisation en courant continu constant, indépendemment des caractéristiques dépendant de la température de la section d'entrée du dit registre de signal ;
   caractérisé en ce qu'il comporte de plus :
   - Un second registre de référence (16) présentant une caractéristique de charge maximale correspondant à une dite fraction donnée de la caractéristique de charge maximale du dit premier registre de référence (14), une source d'alimentation (82) fournissant au dit second registre de référence des charges électriques d'une grandeur correspondant à la dite caractéristique de charge maximale;
   - et en ce que le dit circuit de rétroaction (54 - 77) est connecté aux sections de sortie des deux dits registres de référence (14, 16) pour comparer la tension de sortie correspondant aux charges transférées par les dits registres de référence, et pour fournir une tension de rétroaction à la section d'entrée du dit registre de signal (12) et du dit premier registre de référence (14), la dite tension de rétroaction correspondant à la différence entre la tension de sortie du dit second registre de référence (16) et la tension de sortie du dit premier registre de référence(14).

2. Dispositif à transfert de charges selon la revendication 1, caractérisé en ce que les directions de transfert des charges du dit registre de signal (12), du dit premier registre de référence (14) et du dit second registre de référence (16) sont mutuellement parallèles et en ce que les dits registres partagent un substrat commun (10) et une seule électrode commune (27).

3. Dispositif à transfert de charges selon la revendication 1 ou la revendication 2, caractérisé en ce qu'une grille d'entrée commune (24) relie les sections d'entrée du dit registre de signal (12) et du dit premier registre (14)

4. Dispositif à transfert de charges selon l'une quelconque des revendications 1 à 3, caractérisé en ce que le dit second registre de référence (16) comporte un section de sortie ayant essentiellement la même structure que celle de la section de sortie du dit premier registre de référence (14).

5. Dispositif à transfert de charges selon la revendication 4, caractérisé en ce que le dit premier registre de référence (14) et le dit second registre de référence (16) comportent une grille de sortie commune (42). `

6. Dispositif à transfert de charges selon l'une quelconque des revendications 4 ou 5, caractérisé en ce que le dit premier registre de référence (14) et le dit second registre de référence (16) présentent une grille de précharge commune (40).

7. Dispositif à transfert de charges selon l'une quelconque des revendications 1 à 6, caractérisé en ce que le dit second registre de référence (16) comporte une section d'entrée présentant pratiquement la même structure que celle du dit premier registre de référence (14) sauf que la dite section d'entrée du dit registre de référence présente un canal de transfert de charge plus étroit que celui de la dite section d'entrée du dit premier registre de référence de façon à ce que le rapport de la largeur des dits deux canaux corresponde au rapport des dites caractéristiques de charges maximale.

## Ansprüche

1. Ladungsgekoppeltes Bauelement mit
   - einem Signalregister (12) zum Übertragen elektrischer Ladungen von seinem Eingangsbereich zu seinem Ausgangsbereich;
   - ein erstes Bezugsregister (14) mit einem Eingangsbereich (34) im wesentlichen derselben Struktur wie der Eingangsbereich (22) des Signalregisters, welches erste Bezugsregister elektrische Ladungen von seinem Eingangsbereich zu seinem Ausgangsbereich überträgt; und
   - einer Rückkopplungsschaltung (34, 57) zum Zuführen einer konstanten Gleichspannungs-Vorladung an das Signalregister, unabhängig von der Temperaturcharakteristik des Eingangsbereichs des Signalregisters;
   dadurch gekennzeichnet, daß
   - ein zweites Bezugsregister (16) vorhanden ist mit einem maximalen Ladungsvermögen, das einem vorgegebenen Bruchteil des maximalen Ladungsvermögens des ersten Bezugsregisters (14) genügt, welches zweite Bezugsregister durch eine Spannungsquelle (82) mit elektrischen Ladungen in einem Ausmaß zu versorgen ist, das seinem maximalen Ladungsvermögen entspricht; und
   - die Rückkopplungsschaltung (54 - 77) mit den Ausgangsbereichen der beiden Bezugsregister (14, 16) verbunden ist, um Ausgangsspannungen miteinander zu vergleichen, die Ladungen entsprechen, wie sie von den Bezugsregistern übertragen werden, und zum Zuführen einer Rückkopplungsspannung an den Eingangsbereich des Signalregisters (12) und des ersten Bezugsregisters (14), welche Rückkopplungsspannung der Differenz zwischen der Ausgangsspannung des zweiten Bezugsregisters (16) und der Ausgangsspannung des ersten Bezugsregisters (14) entspricht.

2. Ladungsgekoppeltes Bauteil nach Anspruch 1, **dadurch gekennzeichnet,** daß die Richtungen der Ladungsübertragung des ersten Signalregisters (12) , des ersten Bezugsregisters (14) und des zweiten Bezugsregisters (16) zueinander parallel sind und die Register sich in ein gemeinsames Substrat (10) und eine gemeinsame Elektrode (27) teilen.

3. Ladungsgekoppeltes Bauteil nach Anspruch 1 oder Anspruch 2, **gekennzeichnet durch** ein gemeinsames Eingangsgate (24), das die Eingangsbereiche des Signalregisters (12) und des ersten Bezugsregisters (14) überbrückt.

4. Ladunsgekoppeltes Bauteil nach einem der Ansprüche 1 bis 3, **dadurch gekennzeichnet,** daß das zweite Bezugsregister (16) einen Asugangsbereich mit im wesentlichen derselben Struktur wie der Ausgangsbereich des ersten Bezugsregisters (14) aufweist.

5. Ladungsgekoppeltes Bauteil nach Anspruch 4, **dadurch gekennzeichnet,** daß das erste Bezugsregister (14) und das zweite Bezugsregister (16) ein gemeinsames Ausgangsgate (42) aufweisen.

6. Ladungsgekoppeltes Bauteil nach einem der Ansprüche 4 oder 5, **dadurch gekennzeichnet,** daß das erste Bezugsregister (14) und das zweite Bezugsregister (16) ein gemeinsames Vorladungsgate (40) aufweisen.

7. Ladungsgekoppeltes Bauteil nach einem der Ansprüche 1 bis 6, **dadurch gekennzeichnet,** daß das zweite Bezugsregister (16) einen Eingangsbereich mit im wesentlichen derselben Struktur wie derjenige des ersten Bezugsregisters (14) aufweist, ausgenommen, daß der Eingangsbereich des zweiten Bezugsregisters einen engeren Ladungsübertragungskanal als der Eingangsbereich des ersten Bezugsregisters aufweist, wobei das Verhältnis der Breiten der beiden Kanäle dem Verhältnis der ma-

ximalen Ladungsvermögen entspricht.

# FIG.1

# FIG.2

# FIG.3

# FIG.4

# FIG.5

# FIG.6

# FIG.7